# EUROPÄISCHE PATENTSCHRIFT

(11) **EP 3 658 698 B1**
(45) Veröffentlichungstag und Bekanntmachung des Hinweises auf die Patenterteilung: **28.08.2024**
(21) Anmeldenummer: 18750326.3
(22) Anmeldetag: 25.07.2018
(51) Int. Cl.: C23C 14/16, C23C 14/35, C23C 14/34, H01J 37/34, C22C 1/04, B22F 7/06, B22F 3/105, B22F 3/24

(54) **VERFAHREN ZUR HERSTELLUNG EINER EINPHASIGEN SCHICHT AUS INTERMETALLISCHEN VERBINDUNGEN**
METHOD OF MANUFACTURING A SINGLE PHASE INTERMETALLIC COMPOUND FILM
PROCÉDÉ DE FABRICATION D'UNE COUCHE MONOPHASÉE EN COMPOSÉ INTERMÉTALLIQUE

(30) Priorität: 27.07.2017 DE 102017116972
(43) Veröffentlichungstag der Anmeldung: 03.06.2020
(73) Patentinhaber: Karlsruher Institut für Technologie, 76131 Karlsruhe (DE)
(72) Erfinder: DITTMEYER, Roland, 76133 Karlsruhe (DE); SIEBERT, Martin, 27254 Staffhorst (DE); ARMBRÜSTER, Marc, 09130 Chemnitz (DE); ZIMMERMANN, René, 02625 Bautzen (DE)
(86) Internationale Anmeldenummer: PCT/EP2018/000371
(87) Internationale Veröffentlichungsnummer: WO 2019/020214

(56) Entgegenhaltungen:
- JP-A- H11 175 947
- JP-A- H11 175 947
- US-A- 6 159 625
- US-A- 6 159 625
- US-B1- 6 258 719
- US-B1- 6 258 719
- CHEN D Y ET AL: "Thermally stable PdIn ohmic contacts to n-GaAs via exchange mechanism", JOURNAL OF APPLIED PHYSICS, AMERICAN INSTITUTE OF PHYSICS, US, vol. 81, no. 1, 1 January 1997 (1997-01-01), pages 297, XP012041096, ISSN: 0021-8979, DOI: 10.1063/1.363848
- HUANG M ET AL: "Grain growth in sputtered nanoscale PdIn thin films", THIN SOLID F, ELSEVIER, AMSTERDAM, NL, vol. 449, no. 1-2, 2 February 2004 (2004-02-02), pages 113 - 119, XP004490649, ISSN: 0040-6090, DOI: 10.1016/J.TSF.2003.10.081
- ALEXEEVA O K ET AL: "Preparation of hydride-forming intermetallic films", INTERNATIONAL JOURNAL OF HYDROGEN ENERGY, ELSEVIER SCIENCE PUBLISHERS B.V., BARKING, GB, vol. 20, no. 5, 1 May 1995 (1995-05-01), pages 397 - 399, XP004041160, ISSN: 0360-3199, DOI: 10.1016/0360-3199(94)00063-6
- MAYR LUKAS ET AL: "The catalytic properties of thin film Pd-rich GaPd2in methanol steam reforming", JOURNAL OF CATALYSIS, vol. 309, 31 October 2013 (2013-10-31), pages 231 - 240, XP028804281, ISSN: 0021-9517, DOI: 10.1016/J.JCAT.2013.10.002
- MASUI K ET AL: "Formation of amorphous Al-transition metal (TM: Fe, Co, Ni) binary alloy films by RF-sputtering", JOURNAL OF NON-CRYSTALLINE SOLIDS, NORTH-HOLLAND PHYSICS PUBLISHING. AMSTERDAM, NL, vol. 74, no. 2-3, 1 November 1985 (1985-11-01), pages 271 - 284, XP024062119, ISSN: 0022-3093, [retrieved on 19851101], DOI: 10.1016/0022-3093(85)90074-2
- BANERJEE R ET AL: "Microstructure and magnetic, transport, and optical properties of ordered and disordered Ni-25Al alloy thin films", THIN SOLID F, ELSEVIER, AMSTERDAM, NL, vol. 441, no. 1-2, 22 September 2003 (2003-09-22), pages 255 - 260, XP004450862, ISSN: 0040-6090, DOI: 10.1016/S0040-6090(03)00879-4
- MUNIR Z A ET AL: "The effect of electric field and pressure on the synthesis and consolidation of materials: A review of the spark plasma sintering method", JOURNAL OF MATERIALS SCIENCE, KLUWER ACADEMIC PUBLISHERS, BO, vol. 41, no. 3, 1 February 2006 (2006-02-01), pages 763 - 777, XP019399486, ISSN: 1573-4803, DOI: 10.1007/S10853-006-6555-2
- M. ARMBRÜSTER ET AL: "Al13Fe4 as a low-cost alternative for palladium in heterogeneous hydrogenation", NATURE MATERIALS, vol. 11, no. 8, 10 June 2012 (2012-06-10), GB, pages 690 - 693, XP055515204, ISSN: 1476-1122, DOI: 10.1038/nmat3347
- CHEN D Y ET AL: "Thermally stable PdIn ohmic contacts to n-GaAs via exchange mechanism", JOURNAL OF APPLIED PHYSICS, AMERICAN INSTITUTE OF PHYSICS, US, vol. 81, no. 1, 1 January 1997 (1997-01-01), pages 297, XP012041096, ISSN: 0021-8979, DOI: 10.1063/1.363848
- HUANG M ET AL: "Grain growth in sputtered nanoscale PdIn thin films", THIN SOLID F, ELSEVIER, AMSTERDAM, NL, vol. 449, no. 1-2, 2 February 2004 (2004-02-02), pages 113 - 119, XP004490649, ISSN: 0040-6090, DOI: 10.1016/J.TSF.2003.10.081
- ALEXEEVA O K ET AL: "Preparation of hydride-forming intermetallic films", INTERNATIONAL JOURNAL OF HYDROGEN ENERGY, ELSEVIER SCIENCE PUBLISHERS B.V., BARKING, GB, vol. 20, no. 5, 1 May 1995 (1995-05-01), pages 397 - 399, XP004041160, ISSN: 0360-3199, DOI: 10.1016/0360-3199(94)00063-6
- MAYR LUKAS ET AL: "The catalytic properties of thin film Pd-rich GaPd2in methanol steam reforming", JOURNAL OF CATALYSIS, vol. 309, 31 October 2013 (2013-10-31), pages 231 - 240, XP028804281, ISSN: 0021-9517, DOI: 10.1016/J.JCAT.2013.10.002
- MASUI K ET AL: "Formation of amorphous Al-transition metal (TM: Fe, Co, Ni) binary alloy films by RF-sputtering", JOURNAL OF NON-CRYSTALLINE SOLIDS, NORTH-HOLLAND PHYSICS PUBLISHING. AMSTERDAM, NL, vol. 74, no. 2-3, 1 November 1985 (1985-11-01), pages 271 - 284, XP024062119, ISSN: 0022-3093, [retrieved on 19851101], DOI: 10.1016/0022-3093(85)90074-2
- BANERJEE R ET AL: "Microstructure and magnetic, transport, and optical properties of ordered and disordered Ni-25Al alloy thin films", THIN SOLID F, ELSEVIER, AMSTERDAM, NL, vol. 441, no. 1-2, 22 September 2003 (2003-09-22), pages 255 - 260, XP004450862, ISSN: 0040-6090, DOI: 10.1016/S0040-6090(03)00879-4
- MUNIR Z A ET AL: "The effect of electric field and pressure on the synthesis and consolidation of materials: A review of the spark plasma sintering method", JOURNAL OF MATERIALS SCIENCE, KLUWER ACADEMIC PUBLISHERS, BO, vol. 41, no. 3, 1 February 2006 (2006-02-01), pages 763 - 777, XP019399486, ISSN: 1573-4803, DOI: 10.1007/S10853-006-6555-2
- M. ARMBRÜSTER ET AL: "Al13Fe4 as a low-cost alternative for palladium in heterogeneous hydrogenation", NATURE MATERIALS, vol. 11, no. 8, 10 June 2012 (2012-06-10), GB, pages 690 - 693, XP055515204, ISSN: 1476-1122, DOI: 10.1038/nmat3347

## Beschreibung

Die Erfindung betrifft ein Verfahren zur Herstellung einer einphasigen intermetallischen Schicht einer intermetallischen Verbindung eines einphasigen Katalysatormaterials vom Typ GaₓPd_{y} oder Al₁₃Fe₄ auf einem Substrat gemäß des ersten Patentanspruchs. GaₓPd_{y} wird vorzugsweise durch GaPd₂ gebildet. Einphasige intermetallische Verbindungen, insbesondere katalytisch aktive Partikel und Beschichtungen aus intermetallischen Verbindungen vom Typ GaPd₂ und Al₁₃Fe₄ sind als Katalysatormaterialien grundsätzlich bekannt.

Ein charakteristisches Einsatzgebiet für katalytisch aktive Beschichtungen generell bieten strukturierte Reaktoren, bei denen die katalytisch aktive Beschichtung auf einem strukturierten Substrat mit hoher Oberfläche pro Volumen im Reaktor angeordnet wird, um dadurch eine gute Zugänglichkeit der katalytisch wirksamen Oberfläche zu erreichen. Dies führt zu einem intensiven Kontakt zwischen den strömenden Reaktanden und dem Katalysator, wodurch Stofftransportwiderstände minimiert werden und eine hohe Reaktionsgeschwindigkeit sowie eine hohe Selektivität erreicht werden können. Es existiert eine große Vielfalt solcher strukturierter Substrate. Beispielhaft genannt seien hier metallische Netze, metallische oder keramische Fasergeflechte und Folien mit eingearbeiteten Kanalstrukturen, die quer zur Hauptströmungsrichtung typischerweise Abmessungen im Bereich von einigen Mikrometern bis hin zu einigen Millimetern aufweisen. Insbesondere aus den zuletzt genannten Folien lassen sich, z.B. durch alternierendes Stapeln von Reaktions- und Kühl-/Heizfolien, sogenannte Mikrostrukturreaktoren aufbauen, die zusätzlich zu den minimierten Stofftransportwiderständen zwischen Fluid und Katalysator auch eine sehr hohe Wärmeübertragungsleistung von dem reagierenden Fluid auf ein Wärmeträgerfluid oder umgekehrt ermöglichen. Diese wiederum ist Voraussetzung für eine gute Temperaturkontrolle, die sich günstig auf Ausbeute und Standzeit der Katalysatoren auswirkt, und ebenso für eine effiziente Verwertung der bei der Reaktion freigesetzten Wärme etwa zur Erzeugung von Prozessdampf oder auch effiziente Zuführung der für die Reaktion benötigten Wärme.

Exotherme Hydrierrungen, wie beispielsweise die an intermetallischen Verbindungen vom Typ GaPd₂ oder Al₁₃Fe₄ vorteilhaft durchgeführte Semi-Hydrierung von Acetylen, stellen eine wichtige Klasse von Reaktionen dar, die in strukturierten Reaktoren vorteilhaft durchgeführt werden kann.

Beispielsweise offenbart EP 1 339 485 B1 einen Mikrostrukturreaktor zur Durchführung einer chemischen Reaktion zwischen jeweils zwei Reaktionspartnern, die als Edukte separat in den Mikrostrukturreaktor einführbar und nach erfolgter Reaktion als Produkt daraus abführbar sind. Der Reaktor selbst besteht aus einem abwechselnd schichtweisen Aufbau von flach ausgebildeten, d.h. aus strukturierten Folien bestehenden Strömungskanalmodulen in Mikrostrukturtechnik, wobei jeweils ein erstes Strömungskanalmodul mit Strömungskanälen, die einen Eingang und einen Ausgang aufweisen, für ein erstes Edukt vorgesehen ist, und jeweils ein zweites Strömungskanalmodul mit Strömungskanälen, in die ein zweites Edukt von außen einführbar ist.

Auch die DE 10 2005 022 958 B3 offenbart einen Mikrostrukturreaktor, in diesem Fall zur Durchführung einer chemischen zweiphasigen Hydrierung zwischen zwei Reaktanden. Die Vorrichtung weist einen schichtweisen Aufbau mit strukturierten Folien auf und umfasst eine erste Passagenfraktion mit Kanälen für eine Fluidfraktion, die über eine Vielzahl von Öffnungen in mindestens ein mit einer Schüttung von Partikeln eines Katalysators aufgefüllten Reaktionsvolumen ausmündet.

Einen schichtweisen Aufbau eines Mikrostrukturreaktors zeigt auch DE 10 2012 100 344 A1**.** Das eigentliche Reaktionsmodul ist dabei als separates Modul und Träger für einen Katalysator als Einschub in den Mikroreaktor ausgestaltet.

D. Y. CHEN et al."Thermally stable PdIn ohmic contacts to n-GaAs via exchange mechanism", JOURNAL OF APPLIED PHYSICS, 81(1) (1997) Seite 297, XP012041096, ISSN: 0021-8979, DOI: 10.1063/1.363848, offenbart ein Beschichtungsverfahren, wobei eine einphasige PdIn-Schicht mittels DC-Magnetronsputterprozesses eines PdIn-Verbindungstargets in einer Ar-Atmosphäre abgeschieden wird. M. HUANG et al. "Grain growth in sputtered nanoscale PdIn thin films", THIN SOLID FILMS, 449 (1-2) (2004) Seiten 113-119, XP004490649,ISSN: 0040-6090, DOI: 10.1016/ J.TSF.2003.10.081, offenbart ein Beschichtungsverfahren, das ein einphasiger PdIn Target für den DC-Magnetronsputterprozess in einer Ar-Atmosphäre für die Beschichtung eines Salzsubstrates verwendet, und ein einphasiges kubisches Gefüge der PdIn-Schicht. US 6 159 625 A offenbart ein Verfahren zur Herstellung eines gesinterten Targets aus einer intermetallischen Verbindung und ein magnetisches Aufzeichnungsmedium, das mindestens eine durch Sputtern des gesinterten Targets abgeschiedene Schicht umfasst.

Eine grundsätzliche Problematik bei einem Einsatz katalytisch aktiver Beschichtungen in strukturierten Reaktoren stellt deren Herstellung dar, insbesondere dann wenn es sich um spezielle Materialien wie intermetallische Verbindungen vom Typ GaPd₂ oder Al₁₃Fe₄ handelt, deren Synthese mit hoher spezifischer Oberfläche besonders aufwändig ist.

Aktuell gibt es kein Verfahren um einphasige, dünne, intermetallische GaPd₂ und Al₁₃Fe₄ Schichten im Schichtdickenbereich weniger Nanometer bis zu einigen Mikrometern herzustellen.

Derzeit kann die intermetallische Verbindung GaPd₂ in nanopartikulärer Form synthetisiert werden. Die so erhaltenen Nanopartikel können in eine druckbare Suspension überführt werden und z.B. mittels eines Tintenstrahl- oder Siebdruckverfahrens als Wandbeschichtungen in präformierte Mikrostrukturen gedruckt werden. Im Falle des Druckens von ungeträgerten Nanopartikeln, entsteht jedoch keine Schichtausbildung im eigentlichen Sinne. Stattdessen, werden die Nanopartikel sehr fein und präzise auf der Oberfläche der Mikrostruktur verteilt. Im Fall der Nutzung eines Trägermaterials und des Druckens von auf z.B. Al₂O₃-geträgerten GaPd₂-Nanopartikeln können durch Drop-on-demand Tintenstrahldruck poröse Wandbeschichtungen einstellbarer Dicke im Bereich von 1 - 10 um erzeugt werden. Allerdings sind neben der zeitintensiven Nanopartikelsynthese und der sich anschließenden komplexen Tintenformulierung weitere Nachteile des Tintenstrahldruckens von GaPd₂, dass eine großflächige Beschichtung von Substraten nur mit einer sehr langen Druckzeit möglich ist, ein kontrollierter Trocknungsschritt notwendig ist sowie keine kompakte Schichtbildung mit sehr stark ausgeprägter Schichthaftung erzeugt werden kann. Weiterhin können bislang nicht alle intermetallischen Verbindungen in nanopartikulärer Form dargestellt werden (z. B. Al₁₃Fe₄). Zur Anwendung des Tintenstrahldrucks sind jedoch Partikel mit einem Durchmesser kleiner 1 µm notwendig. Aufgrund dieser Einschränkungen besteht der Bedarf nach einem einfacheren und kostengünstigeren Verfahren zur Synthese katalytisch aktiver Schichten aus den genannten Materialien.

Insbesondere die vorgenannten intermetallischen Katalysatormaterialien vom Typ GaPd₂ oder Al₁₃Fe₄ erfordern für eine zuverlässige Funktion das Vorliegen einer einphasigen Modifikation mit spezifischer Kristallstruktur. Die Ausbildung der intermetallischen Verbindung ist essenziell, da durch die Bildung des charakteristischen Kristallgitters eine Isolierung der katalytisch aktiven Zentren sowie eine Änderung der elektronischen Struktur im Vergleich zu den Elementar- bzw. Legierungsverbindungen erfolgt (M. Armbrüster, K. Kovnir, M. Behrens, D. Teschner, Y. Grin, R. Schlögl, J. Am. Chem. Soc. 2010, 132, 14745-14747 und M. Armbrüster, K. Kovnir, M. Friedrich, D. Teschner, G. Wowsnick, M. Hahne, P. Gille, L. Szentmiklosi, M. Feuerbacher, M. Heggen, F. Girgsdies, D. Rosenthal, R. Schlögl, Y. Grin, Nat. Mater. 2012, 11, 690-693). Diese Effekte führen zu den katalytisch vorteilhaften Eigenschaften bei der Semi-Hydrierung von Acetylen wie beispielsweise einer erhöhten Aktivität und Selektivität im Vergleich zu konventionellen Palladium- oder Legierungskatalysatoren.

Davon ausgehend liegt eine **Aufgabe der Erfindung** darin, ein Verfahren zur Herstellung einer einphasigen intermetallischen Schicht aus intermetallischen Verbindungen insbesondere vom Typ GaₓPd_{y} und Al₁₃Fe₄ auf ein Substrat vorzuschlagen, das sich insbesondere für eine einfache und kostengünstige sowie auch großflächige Beschichtung strukturierter Substrate wie z.B. mikrostrukturierter Folien, metallischer Netze, metallischer oder keramischer Fasern und Fasergeflechte und 3D-gedruckter Strukturen eignet.

Gelöst wird die Aufgabe durch ein Verfahren mit den Merkmalen des Anspruchs 1. Hierauf rückbezogene Unteransprüche geben vorteilhafte Ausgestaltungen wieder.

Die Lösung der Aufgabe basiert auf einem Verfahren zur Herstellung einer einphasigen Schicht intermetallischer Verbindungen vom Typ GaₓPd_{y}, vorzugsweise GaPd₂, oder Al₁₃Fe₄ auf ein Substrat mittels eines DC Magnetron-Sputterverfahrens. Die besondere Schwierigkeit liegt darin, den Sputtervorgang so zu gestalten, dass die Zusammensetzung der intermetallischen Phase über die ganze Schicht sichergestellt ist. Hierzu wird der Einsatz mindestens eines, vorzugsweise genau eines Sputtertargets vorgeschlagen, wobei jedes der im Sputtervorgang eingesetzten Sputtertargets zumindest in der Tiefe, die während des Sputter-Prozesses genutzt wird, vollständig und auch im atomaren Bereich homogen jeweils einphasig nur aus einer der intermetallischen Verbindungen vom Typ GaPd₂ oder Al₁₃Fe₄ gebildet wird.

Ein Sputtertarget ist eine Kathode mit einem Festkörper mit Kathodenfläche aus der vorgenannten einphasigen intermetallischen Verbindung. Erfindungsgemäß ist das Sputtertarget als Schicht aus der einphasigen intermetallischen Verbindung auf einen metallischen Grundkörper als Trägerelement aufgebracht. Im Bereich der Kontaktfläche zu dem das Sputtertarget tragenden Grundkörper, vorzugsweise aus Kupfer, kann es zur Ausbildung einer oder mehrerer ternärer Phasen kommen. Diese sind jedoch nicht am Sputterprozess beteiligt und daher insoweit unschädlich.

Wesentlich ist, dass die intermetallische Verbindung einer Elementkombination, vom Typ GaₓPd_{y}, vorzugsweise GaPd₂, oder Al₁₃Fe₄, in der Schicht einphasig vorliegt und sich nicht auf zwei oder mehrere unterschiedliche in der Schicht befindliche Phasen aufteilt.

Wesentlich ist auch die Verwendung eines oder mehrerer Sputtertargets, im obigen Sinne jeweils bestehend aus einer intermetallischen Verbindung, erfindungsgemäß der abzuscheidenden intermetallischen Verbindung.

Eine intermetallische Verbindung vom Typ GaPd₂ oder Al₁₃Fe₄ ist im Rahmen dieser Patentanmeldung definiert als eine intermetallische Verbindung, die sich aus, vorzugsweise nur den Verbindungen GaPd₂ oder Al₁₃Fe₄ zusammensetzt. Sie umfasst vorzugsweise keine zusätzlichen Dotierungselemente.

Eine einphasige Schicht intermetallischer Verbindungen vom Typ GaPd₂ oder Al₁₃Fe₄ ist definiert als eine Schicht, in der die intermetallische Verbindung einphasig vorliegt. Davon unberührt kann die einphasige Schicht auch weitere mögliche Phasen z.B. aus Verunreinigungen, die aber nicht aus den Elementkombinationen der intermetallischen Verbindung bestehen, enthalten. Vorzugsweise besteht die einphasige Schicht intermetallischer Verbindungen jedoch nur aus der intermetallischen Verbindung vom Typ GaPd₂ oder Al₁₃Fe₄ und enthält vorzugsweise keine zusätzlichen Dotierungselemente.

Die Einphasigkeit der Schicht ist mittels Röntgenstrukturanalyse (XRD) überprüfbar, ohne dass dabei das Material zwingend bis in den atomaren Bereich hin aufgeklärt werden muss. Die Phasenzusammensetzung wird in den Diffraktogrammen wiedergegeben, wobei die Einphasigkeit durch das ausschließliche Auftreten der charakteristischen Reflexe im Diffraktogramm nachweisbar ist.

Nur ein Gleichstrom (DC) Magnetron-Sputterverfahren mit einem einphasigen intermetallischen Sputtertarget intermetallischer Verbindungen im obigen Sinne vorzugsweise vom Typ GaPd₂ bzw. Al₁₃Fe₄ ermöglicht bislang auf technisch einsetzbaren Trägermaterialien eine Herstellung von einphasigen intermetallischen Schichten aus derartigen Systemen im Schichtdickenbereich unterhalb von 10 µm bis zu wenigen Nanometern, vorzugsweise zwischen 5 oder 10 und 500 oder 1000 nm.

Das Verfahren umfasst die folgenden Verfahrensschritte:
- Bereitstellung eines Substrats, vorzugweise aus einem nichtmetallischen anorganischen Werkstoff, vorzugsweise Glas, einem strukturierbaren Halbleiter, vorzugsweise Silizium, oder einem Metall, vorzugsweise eine Eisenbasislegierung wie einem Chrom-Nickel-Stahl,
- Positionieren des Substrats in einer Prozesskammer einer DC Magnetron-Sputteranlage und Evakuierung der Prozesskammer, wobei in der Prozesskammer mindestens je eine Kathode (d.h. ein Sputter-Target) mit einer zum Substrat weisenden Oberfläche aus einer intermetallischen Verbindung vorzugsweise vom Typ GaₓPd_{y} oder Al₁₃Fe₄ angeordnet ist, wobei GaₓPd_{y} weiter bevorzugt durch GaPdz gebildet wird,
- Nutzung eines hochreinen Edelgases (z. B. Argon) als Sputtergas unter Zusatz von Wasserstoff zur Reinigung der Oberfläche des Substrats und des Sputter-Targets,
- simultane Überführung von Materialbestandteilen aus den Kathoden (d.h. den Sputter-Targets) in ein Plasma,
- simultanes Abscheiden der Materialbestandteile aus dem Plasma zu einer Schicht aus einer intermetallischen Verbindung bevorzugt vom Typ GaPd₂ oder Al₁₃Fe₄ mit einphasigem Gefüge auf dem Substrat sowie
- Entnahme des Substrats mit der abgeschiedenen Schicht aus der betreffenden intermetallischen Verbindung aus der Prozesskammer.

Wesentlich ist, dass die intermetallische Verbindung in den Kathoden einphasig vorliegt, und zwar auch bis in den atomaren Bereich. Ein bevorzugtes Verfahren sieht daher eine Aufnahme der Herstellung der Kathoden in das Verfahren vor.

Ein Einsatz von einphasig vorliegenden intermetallischen Verbindungen als Ausgangsmaterial ermöglicht die Herstellung von Targets aus intermetallischen Verbindungen, beispielsweise von GaPd₂- bzw. Al₁₃Fe₄-Targets.

Weiter bevorzugt erfolgt die Herstellung der Kathoden mittels einer Oberflächendiffusion behafteten Transportumlagerung wie z.B. eines Sinterprozesses aus einem Pulver aus der intermetallischen Verbindung, vom Typ GaₓPd_{y} oder Al₁₃Fe₄, wobei GaₓPd_{y} weiter bevorzugt durch GaPd₂ gebildet wird.

Nicht zwingend, aber weiter bevorzugt wird das intermetallische Pulver für den vorgenannten Sinterprozess einphasig synthetisiert, weiter bevorzugt mittels einer Festkörpersynthese gewonnen.

Mittels eines bevorzugt beim vorgenannten Sinterprozess bei der Herstellung der Kathoden (Sputter-Targets) zur Anwendung kommenden Spark-Plasma-Sinterns sind Sputter-Targets dieser intermetallischen Verbindungen einphasig herstellbar.

Bei diesem Verfahren wird das jeweilige intermetallische Pulver in einem ersten Schritt direkt auf dem bevorzugt metallischen Grundkörper zu einem Grünkörper vorverdichtet. Dies erfolgt mechanisch, wobei in einer bevorzugten Ausgestaltung der Grundkörper als Pressstempel in einer Kolbenführung ausgestaltbar und einsetzbar ist. In einem zweiten Schritt erfolgt eine Überführung des Grünkörpers in eine Schutzgasatmosphäre oder ein Vakuum in einen Sinterofen. In diesem erfolgt der eigentliche Sintervorgang, bei dem zunächst weiterer mechanischer Druck auf den Grünkörper aufgeprägt wird und mit diesem der Grünkörper weiter mechanisch verdichtet wird. Unter Beibehaltung dieses weiteren Drucks erfolgt der eigentliche Sintervorgang, bei dem im Grünkörper mittels eines direkten Stromdurchgangs (Gleichstrom) Wärme erzeugt und dieser aufgeheizt wird. Durch viskoses Fließen oder durch (partielles) Aufschmelzen unter hohem Druck insbesondere an den Kontaktbereichen zwischen den Partikeln und anschließendes Abkühlen der Partikel kommt es zur Verschmelzung dieser und damit des Pulvers im Grünkörper. Zugleich kommt es zu einer vorzugsweise stoffschlüssigen Verbindung mit dem Grundkörper der Kathoden (z.B. Kupferplatte) aufgrund atomarer Umlagerungsprozesse durch Diffusion bei der Sinterung. Gegenüber einem herkömmlichen Sintern wird der Grünkörper in vorteilhafter Weise nicht von außen beheizt, sondern durch den direkten Stromdurchgang, d.h. im gesamten Volumen des Grünkörpers.

Der Vorteil in diesem Verfahren liegt darin, dass die Heiz- bzw. Kühlrampen bis hin zu Werten um 1000 K/min wie auch kurze Prozesszeiten (Bereich < 30 min) bei hoher Kompaktierung (> 90 % theoretischer Dichte) realisierbar sind. Durch das vorgenannte Spark-Plasma-Sintern werden die bevorzugt als intermetallische Verbindung vorliegenden Partikel unterhalb des eigentlichen Schmelzpunkts eines Festkörpers aus dem gleichen Material kompaktiert; kristalline Phasen der Partikel werden im Idealfall ohne eine Phasenänderung in das Target überführt.

Die Kolbenführung weist als eine Voraussetzung einer Durchführbarkeit des Spark-Plasma-Sinterns eine elektrische Leifähigkeit unterhalb des Grünkörpers auf und darf keine stoffschlüssige Verbindung mit dem Sinterkörper eingehen (z.B. Kolbenführung aus einer Nicht-Oxid-Keramik).

Die bevorzugte Verwendung des Spark-Plasma-Sinterns dient dabei ausschließlich zur Herstellung der intermetallischen Sputter-Targets. Wesentlich bei einer Anwendung für intermetallische Verbindungen ist, dass insbesondere aufgrund der hohen Aufheiz- und Abkühlraten, vorzugsweise zwischen 29 K/min und 100 K/min, und der damit erforderlichen kurzen Prozesszeiten (Sinterzeiten vorzugsweise ca. 60 min für GaPd₂ und ca. 30 min für Al₁₃Fe₄) eine Bildung anderer Phasen wie z.B. andere intermetallische Verbindungen neben der gewünschten Zielverbindung vermieden oder zumindest behindert wird.

Vorteilhaft beim Aufbau der Kathoden aus einer einphasigen intermetallischen Verbindung mittels Spark-Plasma-Sintern ist eine Begrenzung der Sintertemperatur, vorzugsweise 920 bis 980°C, vorzugsweise 950°C, vorzugsweise 200 bis 300 K unterhalb des Schmelzpunktes, und des dabei anliegenden Drucks (vorzugsweise ca. 200-300 K unterhalb des Schmelzpunktes). Sowohl eine steigende Sintertemperatur als auch ein steigender Druck erhöhen die Gefahr einer ungewünschten Phasenumwandlung und damit einhergehend die Gefahr einer Bildung einer •zweiten Phase. Insbesondere bei einem zu hohen Druck kommt es beispielsweise ab 60 MPa zu einer Phasenumwandlung von Al₁₃Fe₄, d.h. zu einer Zersetzung zur im Phasendiagramm benachbarten intermetallischen Verbindung Al₅Fe₂.

Eine Anwendung des Spark-Plasma-Sinterns zur Herstellung einphasiger intermetallischer Verbindungen als Sputtertargets ist im Rahmen des Stands der Technik weder für das System Al-Fe noch für das System Ga-Pd bekannt.

Erfindungsgemäß besteht mindestens eine oder mehrere Kathoden aus der abzuscheidenden intermetallischen Verbindung, vom Typ GaₓPd_{y} oder Al₁₃Fe₄. Dabei kann diese Schicht vorzugsweise auf einem Grundkörper aufgesintert werden. Der Grundkörper ist zur Sicherstellung eines ausreichenden Wärmeaustausches zwischen Schicht und einer Wärmesenke oder Quelle vorzugsweise an der Substrathalterung aus einem guten Wärmeleiter, vorzugsweise einem Metall, weiter bevorzugt aus Kupfer oder Silber hergestellt. Eine bevorzugte Ausgestaltung der Grundkörper der Kathoden sehen für die aufgesinterte Schicht ebene, vorzugsweise auch runde Flächen vor.

Die Herstellung dünner intermetallischer Schichten mittels DC Magnetron-Sputtern unter Nutzung des vorgenannten intermetallischen Sputter-Targets ermöglicht eine direkte Synthese intermetallischer Schichten. In vorteilhafter Weise erfolgt dabei der Beschichtungsvorgang grundsätzlich ohne eine Phasentransformation unter Beteiligung von Gasphasen-Atomclustern, die aus dem Sputter-Target herausgeschlagen werden, die wiederum eine potentielle Ursache für eine Bildung mehreren Phasen in der Beschichtung darstellen würde. Weiterhin eignet sich dieses Vorgehen in besonderer Weise für die einphasige Beschichtung auch großflächigerer Substrate. Weitere Vorteile sind die vergleichsweise einfache und schnelle Durchführung, der Verzicht auf Lösemittel und dementsprechend kein Anfall flüssiger Abfälle, vergleichsweise geringe Materialkosten und die Möglichkeit mit Hilfe von Masken auf relativ einfache Weise dafür sorgen zu können, dass die Beschichtung nur auf vorgesehenen Stellen erfolgt.

Eine bevorzuge Ausgestaltung des Verfahrens umfasst eine Auslagerung des Substrats mit der über das Verfahren, vorzugsweise mittels des vorgenannten DC Magnetron-Sputterverfahrens abgeschiedenen intermetallischen Schicht bei einer Temperatur zwischen 300 und 900°C, einem Temperaturbereich, in dem in der vorgenannten abgeschiedenen intermetallischen Verbindung Diffusion, d.h. atomare Umlagerung stattfindet, jedoch oberhalb der Tamman-Temperatur, des Beginns der inneren Diffusion bei Kristallen. Eine Auslagerung ist insbesondere für Al₁₃Fe₄ vorteilhaft, beim Typ GaₓPd_{y} und insbesondere GaPd₂, vor allem für dünne Schichten. Im Rahmen von Ausführungsbeispielen erfolgte eine zufriedenstellende Auslagerung von GaPd₂ unter inertem oder reduktivem Gas (Edelgas, N₂, H₂), vorzugsweise Formiergas (Ar und Ar/ 5% H₂) bei 400 bis 500°C, vorzugsweise 450°C sowie von Al₁₃Fe₄ bei 300 bis 850°C. Die Heiz-/Kühlraten wurden im Bereich zwischen 1 bis 5 K/min eingestellt. Durch die Diffusion werden insbesondere überschüssige Kristallisationskeime abgebaut.

Eine bevorzuge Ausgestaltung des Verfahrens umfasst eine Vorbereitung des Substrats vor dem Positionieren des Substrats in einer Prozesskammer einer DC Magnetron-Sputteranlage. Die Vorbereitung umfasst das Aufbringen einer Haftvermittlerschicht auf dem Substrat. Die Haftvermittlerschicht ist vorzugsweise eine oxidische Haftvermittlerschicht, die weiter bevorzugt aus einem Oxid des Materials des Substrats, vorzugsweise ein Metall (vorzugsweise Aluminium und Aluminiumlegierungen, Edelstähle, rostfreie Stähle, Cr-Ni-Legierungen wie Inconel, Hastteloy, Nicrofer etc.) besteht. Die Zusammensetzung der sich ausbildenden Oxidschicht hängt mit dem gewählten Material zusammen. Des Weiteren hängt die Materialauswahl mit der chemischen Reaktion und den Reaktionsbedingungen zusammen. Das Verfahren zur Herstellung dieser Haftvermittlerschicht umfasst hierfür einen bevorzugten Verfahrensschritt, bei dem das Substrat vor dem Positionieren des Substrats in einer Prozesskammer einer DC Magnetron-Sputteranlage zur Ausbildung der genannten oxidischen Haftvermittlerschicht auf dem Substrat unter einer sauerstoffhaltigen Atmosphäre wie z.B. Luft oder Sauerstoff mit einer materialabhängigen Temperatur zwischen 500 und 1000°C, vorzugsweise 600 bis 700°C aufgeheizt wird.

Weitere Prozessparameter und Verfahrensschritte wie Substratvorbehandlung und -konditionierung mittels Wasserstoff- und Argonplasma, Substratanordnung (Abstand und Winkel zum Target), Sputter- und Targettemperatur, BIAS-Spannung, Pulsform sowie Anwendung von DC-, RF- oder Ionisierungssputtern sind für eine Erzielung einer einphasigen Schicht aus intermetallischen Verbindungen auf einem Substrat geeignet einzustellen. Vorteilhaft sind: Argondruck p_{Ar} (vorzugsweise 0,1 bis 5 Pa), Magnetronleistung P (vorzugsweise 20 bis 2000W) und Sputterzeit t (ab 1 min). Der Druck des Argongases hat einen Einfluss auf die Sputterrate. Mit steigendem Druck nimmt die Sputterrate zu, da mehr effektive Argonion-Target-Kollisionen stattfinden. Ab einer gewissen Höhe wird die Sputterrate wieder geringer, da die Wahrscheinlichkeit zunimmt, dass die abgelösten Targetatome und -cluster im Plasma auf ein Argonion treffen und somit die Substratoberfläche nicht mehr erreichen können. Die Magnetronleistung hat einen Einfluss auf das Plasma und die Energie mit der die Argonionen auf das Target treffen und somit auch einen Einfluss auf die Sputterrate. Mithilfe der Sputterzeit lässt sich die Schichthöhe skalieren.

Diese Prozessparameter haben einen Einfluss auf die chemische Zusammensetzung und/oder die strukturellen Eigenschaften der gesputterten Schichten. Die bevorzugten Werte hierzu sind teilweise von der Anlage abhängig. Im Beispiel betrug der Sputtertarget-Substratabstand ca. 6 bis 30 cm, weiter bevorzugt ein Abstand von 6 bis 10 cm. Der Ausrichtung des Substrates zum Target ist mit einem Winkel zwischen 0° (parallel) und 90° (senkrecht) realisierbar. Vorzugsweise wird ein Winkel von 0° verwendet. Die maximale Temeperatur liegt bei 300°C. Die Sputterversuche wurde vorzugsweise ohne eine Tempererierung oder zusätzliche Beheizung durchgeführt. Erfahrungsgemäß erhitzt sich das Substrat in Abhängigkeit der Sputterleistung und -dauer auf Temperaturen zwischen 20 bis 70°C. Die Es wurden eine rechteckige Monpuls-Form verwendet. Es wurden weiter bevorzugt Argondrücke von 0,4 bis 1,4 Pa, Magnetronleistungen von 80 bis 140 W und Sputterzeiten von 1 bis 390 min verwendet.

Ein wesentlicher Unterschied des vorgeschlagenen Verfahrens zu herkömmlichen Verfahren liegt in der erstmaligen Verwendung eines intermetallischen Sputter-Targets für die einphasige Beschichtung eines Substrats mit einer intermetallischen Verbindung, bevorzugt vom Typ GaPd₂ oder Al₁₃Fe₄, im Rahmen eines DC Magnetron-Sputterverfahrens. Der Nachweis der Einphasigkeit der abgeschiedenen intermetallischen Schicht ist sowohl für Al₁₃Fe₄ als auch für GaPd₂ mittels Pulverröntgendiffraktion erbringbar. Ferner ist erst durch die Verwendung von intermetallischen Sputter-Targets die einphasige Herstellung speziell von intermetallischen GaPd₂- und Al₁₃Fe₄-Schichten überhaupt möglich.

Die Besonderheit des vorgeschlagenen Verfahrens begründet sich darin, dass die auf dem Substrat abgeschiedene einphasige Schicht aus einer intermetallischen Verbindung bereits im Sputtertarget vorliegt und während der Ionisation beim Sputtern in Cluster-Form in die Gasphase übergeht. Dadurch muss sich bei der Abscheidung auf dem Substrat nicht erst die intermetallische Verbindung bilden. Insbesondere für die intermetallische Verbindung Al₁₃Fe₄ wird mit diesem Vorgehen die Bildung einer thermodynamisch gegenüber der intermetallischen Verbindung Al₁₃Fe₄ stabileren Nachbarphase wie z.B. AlsFez wirksam unterdrückt.

Das Verfahren eignet sich insbesondere für die Herstellung katalytisch beschichteter strukturierter Elemente für chemische Reaktoren, vorzugsweise auf Basis mikrostrukturierter (Strukturhöhen und -breiten im Mikrometermaßstab, d.h. kleiner 1 mm, vorzugsweise kleiner 500 um) Metallfolien oder metallischer Netze und Fasergeflechte mit einer einphasigen Beschichtung aus einer intermetallischen Verbindung.

Das Verfahren wird anhand eines Ausführungsbeispiels mit der folgenden Figur näher erläutert. Die Figur, die Beschreibung und die Ansprüche enthalten Merkmale auch in Kombination. Der Fachmann wird die Merkmale zweckmäßigerweise auch einzeln betrachten und zu sinnvollen weiteren Kombinationen zusammenfassen.

### Es zeigt beispielhaft

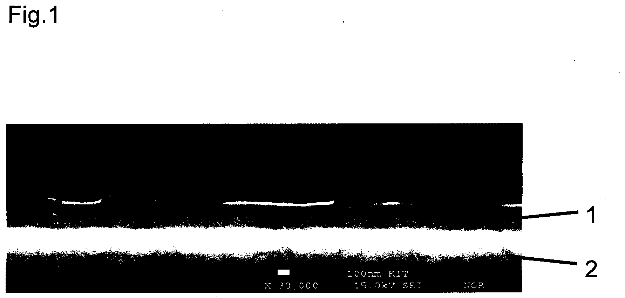

**Fig.1** eine lichtmikroskopische Aufnahme (Auflicht) des Querschliffs eines mit einer einphasigen Schicht **1** aus einer intermetallischen Verbindung des Typs Al₁₃Fe₄ beschichteten Substrats **2.** Die Schichtdicke beträgt ca. 270 nm.

Das Verfahren gemäß des Ausführungsbeispiels zur Herstellung einer einphasigen Schicht aus intermetallischen Verbindungen des Typs Al₁₃Fe₄ auf einer strukturierten Metallfolie als Substrat, wie es gemäß des Schliffbildes nach **Fig.1** dargestellt ist, umfasst folgende Verfahrensschritte:
- Bereitstellung eines Substrats aus einer Eisenbasislegierung (Materialnummer 1.4435)
- Optionale Reinigung des Substrats in einem Ultraschallbad in Ethanol.
- Optionale Aufheizung des Substrats vorzugsweise bei 650°C an Luft, wobei sich auf der zu beschichtenden Oberfläche eine oxidische Haftvermittlerschicht ausbildet.
- Positionieren des Substrats in einer Prozesskammer einer DC Magnetron-Sputteranlage, wobei in der Prozesskammer eine Kathode mit einer zum Substrat weisenden Oberfläche aus der intermetallischen Verbindung Al₁₃Fe₄ angeordnet ist. Das Substrat wurde auf einem Substrathalter mit Halteklammern so fixiert, dass sich der Substrathalter und das Target (Kathode) während des nachfolgenden Beschichtungsvorgangs parallel zueinander befinden. Der Abstand zwischen beiden betrug im Ausführungsbeispiel ca. 6 cm. Dieser Schritt findet vorzugsweise nach dem Einbau der Substrate und der Evakuierung der Prozesskammer statt.
- Evakuierung der Prozesskammer bis auf bevorzugt 3,9·10⁻⁴ Pa.
- Optionale Aufheizung der Prozesskammer vorzugsweise für 30 min auf eine Temperatur zwischen vorzugsweise 200°C und 500°C.
- Sofern die Prozesskammer während der Evakuierung aufgeheizt wurde, erfolgt die Abkühlung auf Raumtemperatur im evakuierten Zustand.
- Prozessablauf des Sputterns, umfassend die seriellen Teilschritte der H₂-Glimmentladung, des Vorsputterns und des Sputterns, wobei im Ausführungsbeispiel die in nachfolgender **Tabelle 1** subsumierten Prozessparameter für die einzelnen Schritte des Prozessablaufs angewandt wurden.
- Die H₂-Glimmentladung dient zur Reinigung der Oberflächen der Prozesskammer, des Substrates und des Targets. Nach Einleitung von Wasserstoff in die Prozesskammer wird ein Wasserstoffplasma erzeugt, wobei das Substrat mit dem Substrathalter im Probenraum eine Rotationsbewegung durchführt und dabei das Plasma durchstreift. Während des Glimmens befindet sich keine Blende zwischen Target und Substrat. Im Anschluss an das Glimmen wird die Prozesskammer evakuiert. Für das Vorsputtern wird Argon in die Prozesskammer eingeleitet und ein Argonplasma erzeugt. Dabei befindet sich eine Blende zwischen Substrat und Target. Es erfolgt eine simultane Überführung von Materialbestandteilen der Kathoden in ein Plasma und ein simultanes Abscheiden der Materialbestandteile auf der Oberfläche der Blende.
- Für das Sputtern wird das gezündete Argonplasma aufrechterhalten und die Blende zwischen Substrat und Target entfernt, sodass ein simultanes Abscheiden der Materialbestandteile aus dem Plasma zu einer Schicht aus der intermetallischen Verbindung Al₁₃Fe₄ mit einphasigem Gefüge auf dem Substrat erfolgt. Dies wird unterstützt durch Anlegen einer BIAS-Spannung an dem Substrat.
- Entnahme des Substrats mit der abgeschiedenen Schicht aus der intermetallischen Verbindung Al₁₃Fe₄ aus der Prozesskammer.

**Tabelle 1:**

| Prozessablauf zum Sputtern von 270 nm dicken Al₁₃Fe₄-Schichten | | | | | | | |
|---|---|---|---|---|---|---|---|
| Schritt | t [min] | BIAS¹ [V] | P [W] | Plasma | p [Pa] | Blende² | Rotation³ [min⁻¹] |
| H₂-Glimmen | 15 | 80-160 | 100 | H2 | 0,8 | 180° | 1,2 |
| Vorsputtern | 10 | - | 100 | Ar | 1,0 | 0° | - |
| Sputtern | 40 | 80 | 100 | Ar | 1,0 | 180° | - |

| | | | | | | | |
|---|---|---|---|---|---|---|---|
| ¹ Als Monopuls-A (Rechteckform) ² Bei Blendenposition 0° befindet sich die Blende zwischen Target und Substrat, bei 180° befindet sich keine Blende zwischen Target und Substrat ³ Es rotiert der Substrathalter inkl. Substrat im Probenraum und durchstreift dabei das Plasma | | | | | | | |

Die gemessene Spannung während des Sputtervorgangs betrug 641 V mit einer Abweichung von unter 0,5 %. Das Target wurde rückseitig mit Kühlwasser (16°C) gekühlt. Die Prozesskammer wurde nicht beheizt.

Die Abscheideraten des Al₁₃Fe₄-Targets wurden in Vorversuchen bestimmt. Daher waren die Prozessparameter so wählbar, dass eine Abscheiderate von etwa 7 nm je min erzielt wird und somit die zu erwartende Schichtdicke nach 40 min Sputtern 270 nm beträgt.

**Tabelle 2:**

| EDX-Ergebnisse zur Bestimmung der Schichtzusammensetzung der Al₁₃Fe₄-Schicht | | | |
|---|---|---|---|
| | Gew.% | Σ | Atom% |
| Al | 58,32 | 1,89 | 74,33 |
| Fe | 41,68 | 3,26 | 25,67 |

## Patentansprüche

1. Verfahren zur Herstellung einer einphasigen Schicht **(1)** aus intermetallischen Verbindungen auf einem Substrat **(2),** umfassend
a) eine Bereitstellung eines Substrats,
b) ein Positionieren des Substrats in einer Prozesskammer einer DC Magnetron-Sputteranlage und Evakuierung der Prozesskammer, wobei in der Prozesskammer mindestens je eine Kathode mit einer zum Substrat weisenden Oberfläche aus einer intermetallischen Verbindung angeordnet ist,
c) eine simultane Überführung von Materialbestandteilen aus den Kathoden in ein Plasma, bei Verwendung eines Edelgases als Sputtergas,
d) ein simultanes Abscheiden der Materialbestandteile aus dem Plasma zu einer intermetallischen Schicht mit einphasigem Gefüge auf dem Substrat sowie
e) eine Entnahme des Substrats mit der abgeschiedenen intermetallischen Schicht aus der Prozesskammer,
wobei
f) die intermetallische Verbindung der mindestens einen Kathode einphasig vorliegt, und zwar auch bis in den atomaren Bereich,
g) die einphasige Schicht auch weitere mögliche Phasen z.B. aus Verunreinigungen, die aber nicht aus den Elementkombinationen der intermetallischen Verbindung bestehen, enthalten kann,
h) die intermetallische Verbindung eine intermetallische Verbindung vom Typ GaₓPd_{y} oder Al₁₃Fe₄ sowie die intermetallische Schicht eine intermetallische Schicht vom Typ GaₓPd_{y} oder Al₁₃Fe₄ ist sowie
i) die Einphasigkeit der abgeschiedenen intermetallischen Schicht mittels Röntgenstrukturanalyse (XRD) überprüfbar, wobei die Phasenzusammensetzung in den Diffraktogrammen wiedergegeben wird, wobei die Einphasigkeit durch das ausschließliche Auftreten der charakteristischen Reflexe im Diffraktogramm nachweisbar ist.

2. Verfahren nach Anspruch 1, **dadurch gekennzeichnet, dass** das GaₓPd_{y} durch GaPd₂ gebildet wird.

3. Verfahren nach einem der Ansprüche 1 oder 2, umfassend eine Herstellung der Kathoden mittels eines Sinterprozesses aus intermetallischem Pulver aus der intermetallischen Verbindung.

4. Verfahren nach Anspruch 3, **dadurch gekennzeichnet, dass** das intermetallische Pulver einphasig synthetisiert ist.

5. Verfahren nach Anspruch 4, **dadurch gekennzeichnet, dass** das einphasig synthetisierte intermetallische Pulver mittels einer Festkörpersynthese gewonnen wird.

6. Verfahren nach einem der Ansprüche 3 bis 5, **dadurch gekennzeichnet, dass** der Sinterprozess ein Spark-Plasma-Sinterprozess ist.

7. Verfahren nach einem der vorgenannten Ansprüche, **dadurch gekennzeichnet, dass** mindestens eine der Kathoden aus einem metallischen Grundkörper und einer auf diesem aufgesinterten Schicht aus der abzuscheidenden intermetallischen Verbindung besteht.

8. Verfahren nach Anspruch 7, **dadurch gekennzeichnet, dass** der Grundkörper aus Kupfer oder Silber ist.

9. Verfahren nach einem der vorgenannten Ansprüche, **dadurch gekennzeichnet, dass** das Substrat mit der abgeschiedenen intermetallischen Schicht bei einer Temperatur zwischen 300 und 850°C ausgelagert wird.

10. Verfahren nach einem der vorgenannten Ansprüche, **dadurch gekennzeichnet, dass** das Substrat aus einem Metall besteht, das vor dem Positionieren des Substrats in einer Prozesskammer einer DC Magnetron-Sputteranlage zur Ausbildung einer oxidischen Haftvermittlerschicht auf dem Substrat mit einer Temperatur zwischen 600 und 700°C aufgeheizt wird.

## Claims

1. Method for producing a single-phase layer (1) from intermetallic compounds on a substrate (2), comprising
a) providing a substrate,
b) positioning the substrate in a process chamber of a DC magnetron sputtering system and evacuating the process chamber, wherein in each case at least one cathode is arranged in the process chamber, with a surface made of an intermetallic compound pointing towards the substrate,
c) simultaneous transferring of material components out of the cathodes into a plasma, with the use of a noble gas as a sputtering gas,
d) simultaneous depositing of the material components from the plasma to an intermetallic layer with a single-phase structure on the substrate, and
e) removing the substrate with the deposited intermetallic layer out of the process chamber,
wherein
f) the intermetallic compound of the at least one cathode is present as a single phase, and specifically also as far as into the atomic range,
g) the single-phase layer can also contain further possible phases, such as impurities, but which do not consist of the element combinations of the intermetallic compound,
h) the intermetallic compound is an intermetallic compound of the type GaₓPd_{y} or Al₁₃Fe₄, and the intermetallic layer is an intermetallic layer of the type GaₓPd_{y} or Al₁₃Fe₄, and
i) the single-phase nature of the deposited intermetallic layer can be testes by means of X-ray structure (diffraction) analysis (XRD), wherein the phase composition is reproduced in the diffractograms, wherein the single-phase nature can be proved by the exclusive occurrence of the characteristic reflexes in the diffractogram.

2. Method according to claim 1, **characterised in that** the GaₓPd_{y} is formed by GaPd₂.

3. Method according to any one of claims 1 or 2, comprising the production of the cathodes by means of a sinter process from intermetallic powder from the intermetallic compound.

4. Method according to claim 3, **characterised in that** the intermetallic powder is synthesised as single-phase.

5. Method according to claim 4, **characterised in that** the single-phase synthesised intermetallic powder is won by means of a solid body synthesis.

6. Method according to any one of claims 3 to 5, **characterised in that** the sinter process is a spark-plasma sinter process.

7. Method according to any one of the preceding claims, **characterised in that** at least one of the cathodes consists of a metallic basic body and a layer sintered onto this formed from the deposited intermetallic compound.

8. Method according to claim 7, **characterised in that** the basic body is made of copper or silver.

9. Method according to any one of the preceding claims, **characterised in that** the substrate with the deposited intermetallic layer is extracted at a temperature of between 300 and 850 °C.

10. Method according to any one of the preceding claims, **characterised in that** the substrate consists of a metal which, before the positioning of the substrate, is heated to a temperature of between 600 and 700 °C in a process chamber of a DC magnetron sputtering system, in order to form an oxidic adhesive layer on the substrate.

## Revendications

1. Procédé de réalisation d'une couche monophasée (1) de liaisons intermétalliques sur un substrat (2) consistant à :
a) fournir un substrat,
b) installer le substrat dans une chambre de traitement d'une installation de pulvérisation magnétron DC et faire le vide dans la chambre de traitement,
* la chambre de traitement ayant au moins une cathode à surface tournée vers le substrat en une liaison intermétallique,
c) transférer simultanément des composants de la matière de la cathode dans un plasma en utilisant un gaz noble comme gaz de pulvérisation,
d) séparer simultanément les composants de matière du plasma en une couche intermétallique avec un réseau monophasé sur le substrat, et
e) enlever le substrat avec la couche intermétallique déposée de la chambre de procédé,
procédé selon lequel
f) la liaison intermétallique d'au moins une cathode est monophasée et cela jusque dans le domaine atomique,
g) la couche monophasée peut comporter également d'autres phases possibles, par exemple, provenant d'impuretés mais qui ne sont pas composées des combinaisons élémentaires de la liaison intermétallique,
h) la liaison intermétallique est une liaison intermétallique de type GaₓPd_{y} ou Al₁₃Fe₄ et la couche intermétallique est une couche de type GaₓPd_{y} ou Al₁₃Fe₄, et
i) le caractère monophasé de la couche métallique, déposée peut être contrôlée par une analyse de structure aux rayons X (XRD), reproduisant la composition de la phase dans des diagrammes de diffraction,
* le caractère monophasé étant prouvé par l'apparition exclusive des reflets caractéristiques dans le diffractogramme.

2. Procédé selon la revendication 1,
**caractérisé en ce que**
GaₓPd_{y} est formé par GaPd₂.

3. Procédé selon l'une des revendications 1 ou 2,
comprenant :
la réalisation de cathodes avec un procédé de frittage à partir d'une poudre intermétallique provenant de la liaison intermétallique.

4. Procédé selon la revendication 3,
**caractérisé en ce que**
la poudre intermétallique est synthétisée de manière monophasée.

5. Procédé selon la revendication 4,
**caractérisé en ce que**
la poudre intermétallique synthétisée de manière monophasée est obtenue par une synthèse de corps solides.

6. Procédé selon l'une des revendications 3 à 5,
**caractérisé en ce que**
le procédé de frittage est un procédé de frittage SPS.

7. Procédé selon l'une des revendications précédentes,
**caractérisé en ce que**
au moins l'une des cathodes est en un corps de base métallique et l'une des couches appliquées par frittage est une liaison intermétallique à déposer.

8. Procédé selon la revendication 7,
**caractérisé en ce que**
le corps de base est en cuivre ou en argent.

9. Procédé selon l'une des revendications précédentes,
**caractérisé en ce que**
le substrat avec la couche intermétallique déposée est dégagé à une température comprise entre 300 et 850°C.

10. Procédé selon l'une des revendications précédentes,
**caractérisé en ce que**
le substrat est en un métal qui, avant le placement du substrat dans une chambre de traitement d'une installation de pulvérisation magnétron DC, pour former une couche d'oxyde adhésive sur le substrat est à une température comprise entre 600 et 700°C.
